# EUROPÄISCHE PATENTSCHRIFT

(11) **EP 2 499 669 B1**
(45) Veröffentlichungstag und Bekanntmachung des Hinweises auf die Patenterteilung: **05.03.2014**
(21) Anmeldenummer: 10759852.6
(22) Anmeldetag: 21.09.2010
(51) Int. Cl.: H01L 27/02, H01L 29/866, H01L 29/872

(54) **SCHUTZELEMENT FÜR ELEKTRONISCHE SCHALTUNGEN**
PROTECTIVE ELEMENT FOR ELECTRONIC CIRCUITS
ÉLÉMENT DE PROTECTION POUR CIRCUITS ÉLECTRONIQUES

(30) Priorität: 11.11.2009 DE 102009046606
(43) Veröffentlichungstag der Anmeldung: 19.09.2012
(73) Patentinhaber: Robert Bosch GmbH, 70442 Stuttgart (DE)
(72) Erfinder: QU, Ning, 72770 Reutlingen (DE); GOERLACH, Alfred, 72127 Kusterdingen (DE)
(86) Internationale Anmeldenummer: PCT/EP2010/063849
(87) Internationale Veröffentlichungsnummer: WO 2011/057841

(56) Entgegenhaltungen:
- DE-A1-102007 045 185
- DE-U1-202005 017 287
- JP-A- 8 107 222
- US-A- 5 502 329

## Beschreibung

### Stand der Technik

Die Erfindung betrifft ein Schutzelement für elektronische Schaltungen.

Viele elektronische Schaltungen und Bauteile werden aus einer Batterie, bzw. einem Akkumulator mit Energie versorgt. Bei manchen Anwendungen ist es möglich, dass die Batterie oder der Akkumulator mit falscher Polarität an die elektronische Schaltung angeschlossen werden kann. In diesem Fall wird der Pluspol der Batterie versehentlich an den Minusanschluss der Schaltung und der Minuspol an den Plusanschluss gelegt. Man nennt diesen Vorgang Verpolung. Beispielsweise kann der Akkumulator eines Kraftfahrzeuges bei Wartungs- oder Reparaturarbeiten versehentlich falsch herum angeschlossen werden. Dadurch können durch die angeschlossenen elektronischen Schaltungen hohe Ströme fließen und sie beschädigen. Als Abhilfemaßnahme kann eine pn-Diode, die zwischen Akkumulator und elektronische Schaltung eingefügt ist, dienen. Bei richtig angeschlossener Batterie fließt Strom durch die Diode in die angeschlossene Elektronik. Bei Verpolung verhindert die Diode einen Stromfluss.

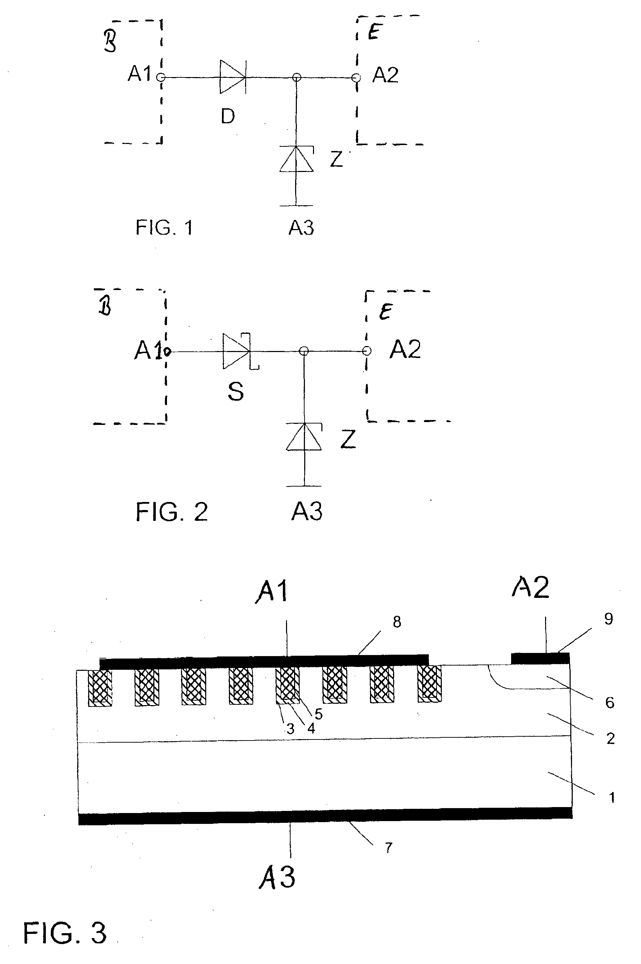

Üblicherweise werden die elektronischen Schaltungen und Bauelemente zusätzlich gegen Überspannungen geschützt, die z. B. beim Betrieb eines Kraftfahrzeuges auftreten können. So können in einem Kfz positive und negative Stör- bzw. Überspannungen auftreten. Beispielsweise können bei plötzlichen Laständerungen bzw. -abschaltungen vom Kfz-Generator positive Spannungen bis ca. 90V in einem Zeitraum bis etwa 400ms erzeugt werden. Zum Schutz der Elektronik wird deshalb häufig eine zusätzliche Z-Diode zur Spannungsbegrenzung eingesetzt. Eine übliche Schutzanordnung, die auch in einem Halbleiter integriert sein kann, ist in Fig. 1 dargestellt. Ein solches Schutzelement enthält eine Verpolschutzdiode D und eine Z-Diode Z für den Überspannungsschutz. Es wird zwischen Stromversorgung also Batterie B oder Akkumulator und Elektronik E geschaltet. Dabei ist der Anschluss A1 mit der Batterie B bzw. der Spannungsversorgung und der Anschluss A2 mit der Elektronik E verbunden. A3 liegt auf Masse. Nachteilig ist der Spannungsabfall von ca. 0,8V - 1V der, je nach Stromstärke, über der Verpolschutzdiode D abfällt. Neben der dabei anfallenden Verlustleistung reduziert sich auch die von der Batterie gelieferte Spannung um diesen Betrag.

Aus der DE 20 2005 017 287 U1 ist bereits die Verwendung von Schottky Dioden als Schutzelemente bekannt.

### Offenbarung der Erfindung

### Vorteile der Erfindung

Die erfindungsgemäße Vorrichtung sowie das erfindungsgemäße Verfahren mit den Merkmalen der beiden unabhängigen Ansprüchen haben den Vorteil, dass die vorstehend genannten Nachteile nicht mehr auftreten. Zur Vermeidung bzw. Verringerung der anfallenden Verlustleistung bzw. der Spannung wird dabei eine Anordnung eingesetzt, bei der die Diode D durch eine Schottkydiode S ersetzt ist. Wegen der geringeren Flussspannung einer Schottkydiode ist der Spannungsabfall über dem Schutzelement geringer. Bei Schottkydioden treten allerdings relativ hohe Leck- oder Sperrströme auf, die den Einsatz bei erhöhten Temperaturen einschränken. Da die Flussspannungen einer Schottkydiode i. a. kleiner als bei pn-Dioden sind, sind auch ihre Sperrströme höher. Außerdem steigt der Sperrstrom einer einfachen Schottkydiode mit zunehmender Sperrspannung an.

Es ist daher eine besonders vorteilhafte Ausgestaltung der Erfindung möglich, indem Schottkydioden verwendet werden, bei denen der spannungsabhängige Anteil des Sperrstroms weitgehend unterdrückt werden kann. Beispiele dafür sind Trench-MOS-Barrier-Junction Dioden bzw. Trench-MOS-Barrier-Schottky Dioden (TMBS)-Dioden oder Trench-Junction-Barrier-Schottky-Dioden (TJBS)-Dioden. Einige dieser Dioden sind im Prinzip aus der DE 694 28 996 T2 bekannt. Es wird vorgeschlagen, die Schottkydiode S in einer erfindungsgemäßen Schutzanordnung durch eine Schottkydiode, die einen sperrspannungsunabhängigen Sperrstrom aufweist, zu ersetzten. Als Schottkydiode werden dabei insbesondere eine (TMBS)- oder (TJBS)-Diode verwendet. Diese Schottkydioden werden insbesondere auch zusammen mit der Überspannungsschutz Z-Diode in einen Halbleiter integriert. Ein solches Schutz element kann in vorteilhafter Weise bei höheren Einsatztemperaturen als eine Anordnung, die gewöhnliche Schottkydioden enthält, betrieben werden. Ist eine Erhöhung der Temperatur nicht erforderlich, kann alternativ auch die Flussspannung einer solchen Anordnung in vorteilhafter Weise noch kleiner gewählt werden.

### Kurze Beschreibung der Zeichnungen

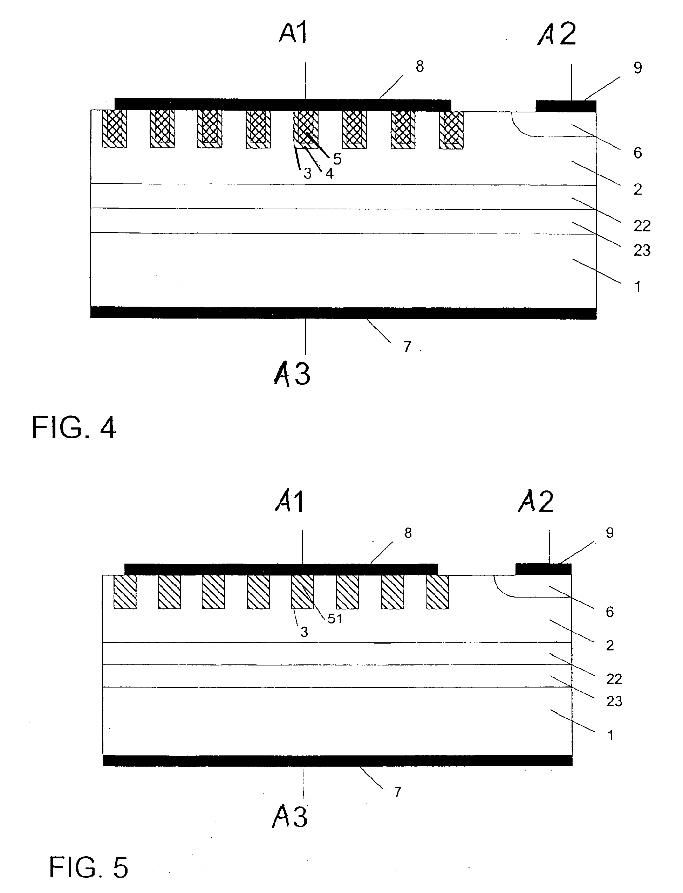

Figur 1 zeigt ein Schaltbild eines herkömmlichen Schutzelements mit pn-Diode D und Z-bzw. Zenerdiode Z. Figur 2 zeigt ein Schaltbild eines erfindungsgemäßen Schutzelements mit Schottkydiode S und Z- bzw. Zenerdiode Z. In Figur 3 ist eine erste erfindungsgemäße Anordnung eines Schutzelements mit intergrierter TMBS-Struktur im Querschnitt dargestellt, wobei die Zeichnung nicht maßstäblich ist. In Figur 4 ist eine zweite und in Figur 5 eine dritte erfindungsgemäße Anordnung eines Schutzelements mit intergrierter TMBS-Struktur im Querschnitt dargestellt, wobei die Zeichnungen ebenfalls nicht maßstäblich sind.

### Ausführungsformen der Erfindung

Figur 2 zeigt ein Schaltbild eines erfindungsgemäßen Schutzelements bzw. einer Schutzanordnung mit Schottkydiode S anstatt pn-Diode und Z- bzw. Zenerdiode Z. Bei dieser Schutzanordnung, die auch in einem Halbleiter integriert wird, dient also als Verpolschutzdiode eine Schottkydiode S und für den Überspannungsschutz eine Z-Diode Z. Die Schutzanordnung wird dabei wird zwischen Stromversorgung also Batterie oder Akkumulator und Elektronik geschaltet. Dabei ist der Anschluss A1 mit der Spannungsversorgung und der Anschluss A2 mit der Elektronik verbunden. A3 liegt auf Masse.

Es wird auch eine Schottkydiode oder es werden Schottkydioden verwendet, bei der oder denen der spannungsabhängige Anteil des Sperrstroms weitgehend unterdrückt werden kann. Beispiele dafür sind TMBS Dioden (Trench-MOS Barrier-Junction Dioden) oder TJBS (Trench-Junction-Barrier-Schottky-Dioden).

Weiterhin werden Schottkydioden S in einer erfindungsgemäßen Schutzanordnung durch eine Schottkydiode, die einen sperrspannungsunabhängigen Sperrstrom aufweist, ersetzt. Als Schottkydiode wird dabei insbesondere eine TMBS- oder TJBS-Diode verwendet. Diese Schottkydioden werden insbesondere auch zusammen mit der Überspannungsschutz Z-Diode in einen Halbleiter integriert. Ein solches Schutzelement kann bei höheren Einsatztemperaturen als eine Anordnung, die gewöhnliche Schottkydioden enthält, betrieben werden. Ist eine Erhöhung der Temperatur nicht erforderlich, kann alternativ auch die Flussspannung einer solchen Anordnung in vorteilhafter Weise noch kleiner gewählt werden.

In Fig. 3 ist ein Beispiel einer integrierten Anordnung schematisch im Querschnitt dargestellt. Auf einem p-dotierten Siliziumsubstrat **1** befindet sich eine n-dotierte Siliziumschicht **2** in die mindestens zwei mit dünnem Oxid **4** und dotiertem Polysilizium **5** gefüllte Gräben **3** eingebracht sind. Außerdem befindet sich an mindestens einer Stelle ein hoch n-dotierter Bereich **6.** Die Bereiche **2** und **5** sind mit einer Metallisierungsschicht **8,** die Bereiche **6** mit einer Metallisierungsschicht **9** und der Bereich **1** mit einer Metallisierungsschicht **7** versehen.

Die Metallisierungsschicht **8** bildet mit der n-dotierten Schicht **2** im Bereich zwischen den Gräben **3** den eigentlichen Schottkykontakt und zusätzlich mit der dotierten Polysilizizumschicht **5** einen ohmschen Kontakt. Sie dient als Anschluss **A1.** Durch geeignete Wahl des Metalls der Metallisierungsschicht **8** kann die Flussspannung der Schottkydiode S festgelegt werden. Üblicherweise besteht die Metallisierungsschicht **8** aus mehreren Schichten; so kann sich über dem eigentlichen Schottkymetall z. B. eine Schicht aus Aluminium befinden. Als "Schottky-Metall" der Metallisierungsschicht **8** findet aber meist keine einfache Metallschicht, sondern eine Silizidschicht, also eine chemische Verbindung von Metall und Silizium wie z. B. TiSi₂, Verwendung. Die Schichten **9** und **7** bilden ohmsche Kontakte mit den hoch n- bzw. p-dotierten Schichten **6** und **1** und dienen als die Anschlüsse **A2** und **A3.** Auch sie können aus einem Mehrlagenmetallsystem gemäß dem Stand der Technik bestehen.

Geometrie und Dotierkonzentrationen werden entsprechend der gewünschten Sperreigenschaften des Schutzelementes gewählt. So kann z. B. für eine 20V-Applikation die Dicke der n-dotierten Schicht **2** etwa 3µm, die Tiefe der hoch n-dotierten Schicht **6** 2µm, die Tiefe der Gräben **3** 1 - 2µm, die Breite und der Abstand zwischen den Gräben z. B. 0,5µm betragen. Die Dotierkonzentrationen der Schichten **1, 2** und **6** können z. B. 1·10¹⁹, 3·10¹⁶ und 1·10²⁰ cm⁻³ aufweisen. Die Breite der Gräben kann auch größer gewählt werden, ohne dass das vorteilhafte Sperrstromverhalten beeinflusst wird.

Zusätzliche, dem Stand der Halbleitertechnik entsprechende Rand- und Passivierungsstrukturen sind in Ausführungsbeispielen nicht eingezeichnet. Ebenfalls sind die üblicherweise an der Chipoberfläche vorhandenen Oxid- oder sonstige dielektrische Schichten aus Gründen der Übersichtlichkeit weggelassen.

Ein erstes Ausführungsbeispiel der Erfindung ist in Fig. 4 dargestellt. In diesem Fall weist der untere Teil des n-dotierten Bereichs **2** eine hoch n-dotierte vergrabene Schicht (Burried Layer) **22** mit z. B. einer Dicke von 5µm und einer Dotierkonzentration von ca. 1-10¹⁹ cm⁻³ auf. Unterhalb der vergrabenen Schicht **22** befindet sich eine etwa 2 µm dicke n-dotierte Schicht **23,** die dieselbe Dotierkonzentration wie die Schicht **2** aufweist. In Folge ihrer hohen Leitfähigkeit reduziert die vergrabene Schicht **22** den Bahnwiderstand, der beim Stromfluss vom Schottkykontakt **8 - 2** zum hoch n-dotierten Bereich **6** auftritt. Da die Durchbruchsspannung der Z-Diode von der Dotierungskonzentration der p-Schicht **1** und der anschließenden n-dotierten Schicht bestimmt wird, muss zwischen der hoch n-dotierten Schicht **22** und der Schicht **1** eine niedriger n-dotierte Schicht **23** vorhanden sein. Natürlich kann die Dicke der vergrabenen hoch n-dotierten Schicht **22** auch größere Werte aufweisen. Damit lässt sich der Bahnwiderstand in vorteilhafter Weise noch weiter reduzieren.

In einem neuen erfindungsgemäßen Herstellungsprozess kann die Dicke der vergrabenen Schicht sogar auf Werte von weit über 200µm erhöht werden. Dadurch kann der Bahnwiderstand noch weiter über das übliche Maß hinaus reduziert werden. Im Gegensatz zu den üblichen Herstellungsverfahren, bei denen man die n-dotierte Schicht **2** als Epitaxieschicht auf einem p-dodierten Substrat **1** abscheidet, beginnt der Herstellungsprozess des neuen erfindungsgemäßen Herstellungsverfahrens mit einem, z. B. 200µm dicken hoch n-dotierten Substratwafer, der als vergrabene Schicht **22** dient. Anschließend werden auf beiden Seiten des Substrates **22** n-dotierte Epitaxieschichten **2** bzw. **23** aufgebracht. Über der n-dotierten Epitaxieschicht **23** wird eine weitere Epitaxieschicht abgescheiden, die eine hohe p-Dotierung aufweist und als p-dotierte Schicht **1** dient. Danach erfolgt in üblicher Weise das Einbringen der Gräben **3** und der weiteren Schichten bzw. Strukturen.

Alternativ kann der weitere p-dotierte Epitaxieschritt zur Herstellung der p-dotierten Schicht **1** entfallen. Stattdessen kann die p-Dotierung **1** auch mittels Ionenimplantation oder mit einem sonstigen, üblichen Verfahren eingebracht werden.

In Fig. 5 ist ein Ausführungsbeispiel dargestellt, das im Gegensatz zum Beispiel gemäß Fig. 4 eine TJBS-Diode anstatt einer TMBS-Diode enthält. Bezeichnungen und Aufbau entsprechen sich bis auf den Bereich des Grabens **3.** Anstelle einer dünnen Oxidschicht **4** befindet sich in den Gräben eine p-dotierte Siliziumschicht **51.** An Stelle der p-dotierten Siliziumschicht **51** kann auch eine hoch p- dotierte Polysiliziumschicht Verwendung finden. Weitere Ausführungen, wie p-dotierte Bereiche an der Oberseite der Gräben und Metall 8, bzw. Polysilizium in den Gräben sind denkbar.

Die integrierten Schutzelemente nach Fig. 3 - 5 können ganz oder teilweise mit einer leitfähigen Metallisierung versehen sein und auf Metallkörper, wie z. B. Kupfer gelötet sein. Durch die große Wärmekapazität kann die Wärme bei kurzeitigen Störimpulsen in diese Körper übergehen und so einen unzulässig hohen Temperaturanstieg im Halbleiter verhindern. Insbesondere können die Metallschichten **7** und **8** an Metallkörper angelötet oder sonst wie verbunden sein.

## Patentansprüche

1. Schutzelement mit wenigstens einer Schottkydiode (S) und wenigstens einer Z-oder Zenerdiode (Z), die zwischen eines Stromversorgung und einer Elektronik liegen, wobei die Anode der Schottkydiode (S) mit der Stromversorgung und die Kathode der Schottkydiode (S) mit der Elektronik und der Kathode der Zenerdiode verbunden ist und deren Anode mit Masse in Verbindung steht, **dadurch gekennzeichnet, dass** die Schottkydiode (S) eine Trench-MOS-Barrier-Schottky Diode (TMBS)-Diode oder eine Trench-Junction-Barrier-Schottky-Diode (TJBS)-Diode ist, die als integrierte Halbleiteranordnung ausgebildet sind und ein p-dotiertes Substrat aufweist, das als Anode der Z- oder Zenerdiode (Z) dient und dass eine vergrabene hoch n-dotierte Schicht (22) vorgesehen ist.

2. Schutzelement nach Anspruch 1, **dadurch gekennzeichnet, dass** alle Dotierungen von entgegen gesetztem Leitfähigkeitstyp sind.

3. Schutzelement nach einem der vorhergehenden Ansprüchen 1 oder 2, **dadurch gekennzeichnet, dass** Gräben (3) vorhanden sind und die Gräben (3) über eine rechteckige Form, eine U- oder über eine sonstige Form verfügen.

4. Schutzelement nach einem oder mehreren der vorhergehenden Ansprüchen, **dadurch gekennzeichnet, dass** die Gräben (3) in Streifenanordnung oder als Inseln angeordnet sind, wobei die Inseln insbesondere kreisförmig oder sechseckig oder sonst wie gestaltet sind.

5. Schutzelement nach einem der vorhergehenden Ansprüche, **dadurch gekennzeichnet, dass** Metallschichten vorhanden sind und einige oder alle Metallschichten lötbar ausgeführt sind und insbesondere das das integrierte Schutzelement auf bzw. zwischen Metallkörper gelötet ist.

6. Verfahren zur Herstellung eines Schutzelementes nach einem der vorhergehenden Ansprüchen, **dadurch gekennzeichnet, dass** auf einem dicken hoch n-dotierten Substratwafer, der als vergrabene Schicht (22) dient auf beiden Seiten n-dotierte Epitaxieschichten (2) oder (23) aufgebracht werden und über der n-dotierten Epitaxieschicht (23) eine weitere p-dotierte Epitaxieschicht (1) abgeschieden wird und danach das Einbringen der Gräben (3) und der weiteren Schichten bzw. Strukturen erfolgt.

7. Verfahren zur Herstellung eines Schutzelementes nach einem der vorhergehenden Ansprüchen 1 bis 6, **dadurch gekennzeichnet, dass** auf einem dicken hoch n-dotierten Substratwafer, der als vergrabene Schicht (22) dient auf beiden Seiten n-dotierte Epitaxieschichten (2) oder (23) aufgebracht werden und bei dem in die n-dotierte Schicht (23) eine p-dotierte Schicht (1) mittels Ionenimplantation oder sonst einem andern üblichen Verfahren eingebracht wird und Gräben (3) und weitere Schichten bzw. Strukturen eingebracht werden.

## Claims

1. Protective element comprising at least one Schottky diode (S) and at least one Zener diode (Z) which are connected between a power supply and an electronic system, wherein the anode of the Schottky diode (S) is connected to the power supply and the cathode of the Schottky diode (S) is connected to the electronic system and the cathode of the Zener diode, and the anode of the latter is connected to earth, **characterized in that** the Schottky diode (S) is a trench MOS barrier Schottky (TMBS) diode or a trench junction barrier Schottky (TJBS) diode designed as an integrated semiconductor arrangement and having a p-doped substrate, which serves as the anode of the Zener diode (Z), and **in that** a buried highly n-doped layer (22) is provided.

2. Protective element according to Claim 1, **characterized in that** all dopings are of the opposite conductivity type.

3. Protective element according to either of the preceding Claims 1 and 2, **characterized in that** trenches (3) are present and the trenches (3) have a rectangular shape, a U-shape or some other shape.

4. Protective element according to one or more of the preceding claims, **characterized in that** the trenches (3) are arranged in strip arrangement or as islands, wherein the islands are embodied in particular in a circular fashion or in a hexagonal fashion or in some other fashion.

5. Protective element according to any of the preceding claims, **characterized in that** metal layers are present and some or all of the metal layers are embodied in a solderable fashion, and in particular **in that** the integrated protective element is soldered onto or between metal bodies.

6. Method for producing a protective element according to any of the preceding claims, **characterized in that** on a thick highly n-doped substrate wafer, which serves as a buried layer (22), n-doped epitaxial layers (2) or (23) are applied on both sides and a further p-doped epitaxial layer (1) is deposited above the n-doped epitaxial layer (23), and the trenches (3) and the further layers or structures are then introduced.

7. Method for producing a protective element according to any of the preceding Claims 1 to 6, **characterized in that** on a thick highly n-doped substrate wafer, which serves as a buried layer (22), n-doped epitaxial layers (2) or (23) are applied on both sides, and wherein a p-doped layer (1) is introduced into the n-doped layer (23) by means of ion implantation or some other customary method and trenches (3) and further layers or structures are introduced.

## Revendications

1. Elément de protection comportant au moins une diode Schottky (S) et au moins une diode Z ou Zener (Z) qui sont disposées entre une alimentation électrique et une électronique, dans lequel l'anode de la diode Schottky (S) est connectée à l'alimentation électrique, et la cathode de la diode Schottky (S) est connectée à l'électronique et à la cathode de la diode Zener et son anode est connectée à la masse, **caractérisé en ce que** la diode Schottky (S) est une diode barrière Schottky MOS à tranchée (TMBS, Trench MOS Barrier Schottky) ou une diode barrière Schottky à jonction et tranchée (TJBS, Trench Junction Barrier Schottky) réalisées sous la forme d'un dispositif à semi-conducteur intégré comprenant un substrat dopé de type p utilisé en tant qu'anode de la diode Z ou Zener (Z) et **en ce qu'**il est prévu une couche enterrée à fort dopage de type n (22).

2. Elément de protection selon la revendication 1, **caractérisé en ce que** tous les dopages ont des types de conductivité opposés.

3. Elément de protection selon l'une quelconque des revendications 1 ou 2 précédentes, **caractérisé en ce que** des tranchées (3) sont présentes et **en ce que** les tranchées (3) ont une forme rectangulaire, une forme en U ou toute autre forme.

4. Elément de protection selon l'une ou plusieurs des revendications précédentes, **caractérisé en ce que** les tranchées (3) sont agencées en bandes ou en îlots, dans lequel les îlots présentent notamment une forme circulaire ou hexagonale ou autre.

5. Elément de protection selon l'une quelconque des revendications précédentes, **caractérisé en ce que** des couches métalliques sont présentes et **en ce que** certaines ou la totalité des couches métalliques sont réalisées de manière à pouvoir être soudées et notamment **en ce que** l'élément de protection intégré est soudé sur ou entre des corps métalliques.

6. Procédé de fabrication d'un élément de protection selon l'une quelconque des revendications précédentes, **caractérisé en ce que** des couches épitaxiales dopées de type n (2) ou (23) sur les deux faces sont appliquées sur une plaquette de substrat épaisse à fort dopage de type n qui est utilisée en tant que couche enterrée (22) et **en ce qu'**une couche épitaxiale dopée de type p supplémentaire (1) est déposée sur la couche épitaxiale dopée de type n (23) et **en ce que** l'introduction des tranchées (3) et des couches ou structures supplémentaires est ensuite effectuée.

7. Procédé de fabrication d'un élément de protection selon l'une quelconque des revendications 1 à 6 précédentes, **caractérisé en ce que** des couches épitaxiales dopées de type n (2) ou (23) sur les deux faces sont appliquées sur une plaquette de substrat épaisse à fort dopage de type n qui est utilisée en tant que couche enterrée (22) et lors duquel une couche dopée de type p (1) est incorporée dans la couche dopée de type n (23) par implantation ionique ou sinon un autre procédé usuel et **en ce que** des tranchées (3) et des couches ou structures supplémentaires sont incorporées.
